# FASCICULE DE BREVET EUROPEEN

(11) **EP 2 145 856 B1**
(45) Date de publication et mention de la délivrance du brevet: **12.03.2014**
(21) Numéro de dépôt: 08160141.1
(22) Date de dépôt: 10.07.2008
(51) Int. Cl.: B81C 99/00, B81C 1/00, G04B 13/02, G04D 3/00

(54) **Procédé de fabrication d'une pièce micromécanique**
Verfahren zur Herstellung eines mikromechanischen Bauteils
Method of manufacturing a micromechanical part

(43) Date de publication de la demande: 20.01.2010
(73) Titulaire: The Swatch Group Research and Development Ltd., 2074 Marin (CH)
(72) Inventeur: Dinger, Rudolf, 2024, Saint-Aubin (CH); Ravenel, Thierry, 2068, Hauterive (FR)
(74) Mandataire: Couillard, Yann Luc Raymond

(56) Documents cités:
- PERRET A: "Le Silicium Comme Matériau Dans La Fabrication De Pièces Mécaniques" BULLETIN DE LA SOCIETE SUISSE DE CHRONOMETRIE, SSC, NEUCHATEL, CH, no. 38, 9 novembre 2001 (2001-11-09), pages 27-29, XP002460036
- NOELL W ET AL: "MEMS for a watches" MICRO ELECTRO MECHANICAL SYSTEMS, 2004. 17TH IEEE INTERNATIONAL CONFER ENCE ON. (MEMS) MAASTRICHT, NETHERLANDS 25-29 JAN. 2004, PISCATAWAY, NJ, USA,IEEE, US, 25 janvier 2004 (2004-01-25), pages 1-4, XP010767811 ISBN: 978-0-7803-8265-7

## Description

### Domaine de l'invention

L'invention se rapporte à un procédé de fabrication d'une pièce mécanique réalisée à base d'un matériau micro-usinable et, plus particulièrement, une telle pièce destinée à être utilisée pour la fabrication d'une pièce d'horlogerie.

### Arrière plan de l'invention

Il est connu de fabriquer une partie d'une pièce d'horlogerie en matériau à base de silicium cristallin. Un exemple d'un tel procédé est décrit dans le document "Le Silicium Comme Matériau Dans La Fabrication De Pièces Mécaniques" de André Perret, BULLETIN DE LA SOCIETE SUISSE DE CHRONOMETRIE, no. 38, 9 novembre 2001, pages 27-29. En effet, l'utilisation d'un matériau micro-usinable comme le silicium cristallin présente des avantages en terme de précision de fabrication grâce aux avancées des procédés actuels notamment dans le domaine de l'électronique. Ainsi, s'il apparaît possible de fabriquer des spiraux, il n'est pas encore possible d'appliquer les matériaux micro-usinables à toutes les parties d'une pièce d'horlogerie du fait de leurs caractéristiques tribologiques insuffisantes. De plus, les procédés actuels de fabrication restent complexes à mettre en oeuvre et imposent la manipulation directe des pièces fabriquées au risque de les détériorer.

### Résumé de l'invention

Le but de la présente invention est de pallier tout ou partie les inconvénients cités précédemment en proposant un procédé qui autorise, de manière simple, la fabrication de qualité d'une pièce micromécanique pouvant être appliquée à la plupart des parties mécaniques horlogères. De plus, le procédé permet un assemblage préalable fiable de la pièce en évitant toute manipulation de ses parties fonctionnelles afin que la pièce soit prête à être montée dans un dispositif tel qu'une pièce d'horlogerie sans avoir à la toucher.

A cet effet, l'invention se rapporte à un procédé de fabrication d'une pièce mécanique comportant les étapes suivantes :
a) se munir d'un substrat en un matériau micro-usinable ;
b) graver par photolithographie, dans la totalité de l'épaisseur dudit substrat, un motif comportant ladite pièce ;
   **caractérisé en ce qu**'il comporte en outre les étapes suivantes :
c) monter sur un support ledit substrat gravé afin de laisser accessibles les faces supérieure et inférieure de ce dernier ;
d) déposer un revêtement sur la surface extérieure de ladite pièce de meilleure qualité tribologique que ledit matériau micro-usinable ;
e) libérer la pièce du substrat.

Conformément à d'autres caractéristiques avantageuses de l'invention :
- l'étape c) comporte les étapes : f) guider le substrat par rapport audit support à l'aide de moyens d'alignement afin d'orienter fiablement ledit substrat et g) glisser le substrat contre au moins un axe solidaire du support jusqu'à buter contre un épaulement dudit au moins un axe réalisé à distance dudit support afin de maintenir en hauteur le substrat par rapport audit support ;
- les moyens d'alignement sont situés plus haut que ledit au moins un axe afin de garantir la consécutivité des étapes f) puis g) ;
- le support comporte plusieurs moyens d'alignement afin d'améliorer le guidage de l'étape f) ;
- lors de l'étape b), au moins un pont de matière est gravé dans le motif afin de maintenir solidaire la pièce avec le substrat ;
- ledit au moins un pont de matière comporte une section rétrécie à l'extrémité reliée à ladite pièce permettant de créer une zone de faiblesse apte à faciliter l'étape e) ;
- l'étape e) est réalisée par déplacement relatif entre le substrat et la pièce afin de casser ledit au moins un pont de matière ;
- après l'étape e), le procédé comporte l'étape : h) assembler une attache sur ladite pièce afin que cette dernière soit prête à être montée sans avoir à toucher la partie en matériau micro-usinable ;
- l'étape h) comporte les étapes : i) monter un contre-support munis de fourchettes sur ledit support afin que les fourchettes coopèrent avec ladite pièce, j) retourner l'ensemble support - contre-support puis retirer le support afin de faire coulisser ladite pièce contre les fourchettes et k) monter une attache sur la pièce ;
- l'étape i) comporte les étapes : guider le contre-support par rapport audit support à l'aide de moyens d'alignement afin d'orienter fiablement ledit contre-support et glisser au moins un tube et les fourchettes contre respectivement un axe solidaire du support et la pièce jusqu'à buter contre un épaulement dudit axe afin de préparer le retournement de l'ensemble support - contre-support ;
- les étapes e) et d) peuvent être interverties ;
- plusieurs pièces sont fabriquées à partir du même substrat ;
- ledit matériau micro-usinable étant choisi parmi le groupe comprenant du silicium cristallin, de la silice cristalline et de l'alumine cristalline.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation d'un substrat après une étape de photolithographie ;
- la figure 2 est un agrandissement d'une partie de la figure 1;
- la figure 3 est une représentation d'une étape de montage sur un support selon l'invention ;
- la figure 4 est une représentation d'une étape de dépôt d'un revêtement ;
- la figure 5 est une représentation d'une étape de montage d'un contre-support selon l'invention ;
- la figure 6 est une représentation d'une étape de retournement selon l'invention ;
- la figure 7 est une représentation d'une étape d'assemblage d'une attache selon l'invention ;
- la figure 8 est un schéma fonctionnel du procédé de l'invention.

### Description détaillée des modes de réalisation préférés

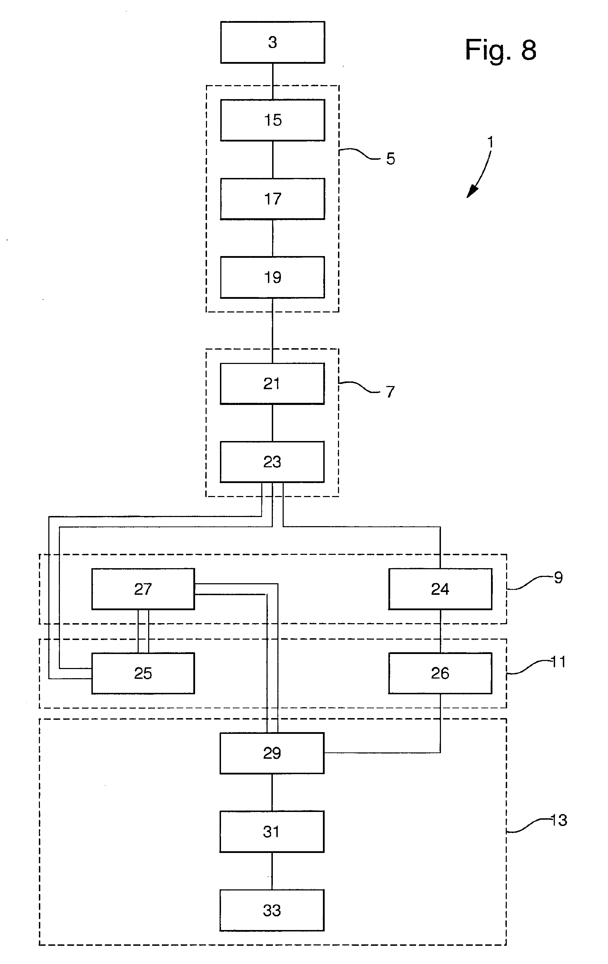

Dans l'exemple illustré à la figure 8, on peut voir le schéma fonctionnel d'un procédé généralement annoté 1. Le procédé 1 comporte principalement six étapes 3, 5, 7, 9, 11 et 13 destinées à fabriquer une pièce mécanique 51 dont l'âme est réalisée à base d'un matériau micro-usinable. En effet, un matériau micro-usinable, grâce à ses précisions inférieures au micromètre, est particulièrement utile pour la fabrication d'un élément, par exemple, d'une pièce d'horlogerie et remplace avantageusement un matériau métallique utilisé habituellement.

Dans l'explication ci-après, le matériau micro-usinable peut être à base de silicium cristallin comme, par exemple, du silicium monocristallin, de la silice cristalline comme du quartz ou encore de l'alumine cristalline comme du corindon (également appelé saphir synthétique). Evidemment, d'autres matériaux micro-usinables peuvent être envisagés.

L'étape 3 consiste à se munir d'un substrat 53 en matériau micro-usinable comme, par exemple, une plaquette en silicium monocristallin utilisée pour la fabrication de composants électroniques (également appelé « wafer » en anglais). Préférentiellement, une phase d'amincissement est prévue lors de l'étape 3 afin d'adapter l'épaisseur finale de la pièce 51. Une telle phase peut être réalisé par un procédé de rodage mécanique ou chimique (également connu sous les termes anglais « back lapping »).

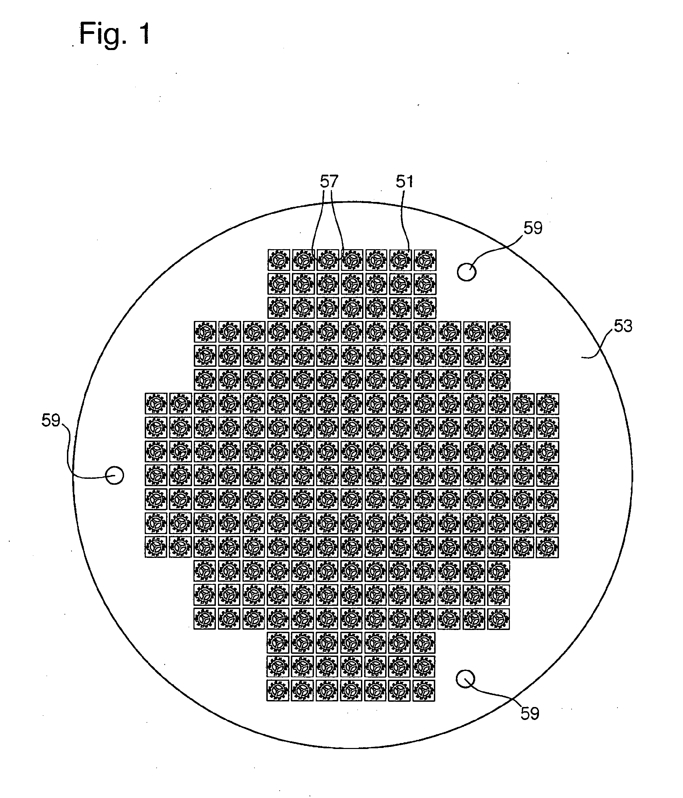

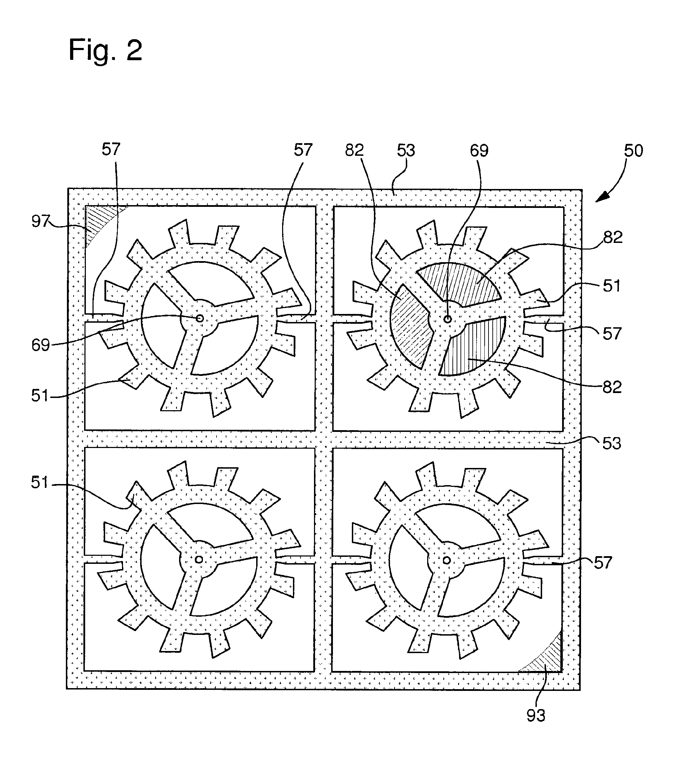

L'étape 5 consiste à réaliser par photolithographie, dans la totalité de l'épaisseur du substrat 53, un motif 50 comportant la pièce mécanique 51 à fabriquer. Avantageusement, comme visible aux figures 1 et 2, la taille, plus grande, du substrat 53 par rapport à celle de la pièce 51 autorise la gravure de plusieurs motifs 50 et donc la fabrication de plusieurs pièces 51 à partir du même substrat 53.

Dans l'exemple illustré aux figures 1 et 2, chaque pièce mécanique 51 est une roue d'échappement pour une pièce d'horlogerie. Bien évidemment, la procédé 1 permet de fabriquer d'autres parties d'une pièce d'horlogerie mais également, comme expliqué ci-après, plusieurs parties différentes sur un même substrat 53.

L'étape 7 consiste à monter sur un support 55' le substrat 53 gravé afin de laisser accessibles ses faces supérieure et inférieure. Cette étape permet de faciliter la mise en oeuvre de l'étape 9 consistant à déposer un revêtement sur la surface extérieure de la pièce 51 de meilleure qualité tribologique que ledit matériau micro-usinable. En effet, la mise en hauteur du substrat 53 par rapport au support 55' permet de faciliter le dépôt du revêtement en ce qu'il facilite l'accessibilité aussi bien sur le dessus, sur l'épaisseur et sur le dessous de chaque pièce 51.

L'étape 9 permet de déposer un revêtement qui remplace avantageusement des qualités tribologiques insuffisantes éventuelles du matériau micro-usinable.

Un tel revêtement peut être, par exemple, à base d'un allotrope de carbone. Il peut ainsi être envisagé de déposer un revêtement de carbone cristallin comme du diamant synthétique par dépôt chimique en phase vapeur (également connu sous l'abréviation anglaise « CVD »). Il peut également être déposé du carbone amorphe comme du carbone sous forme diamant (également connu sous l'abréviation anglaise «DLC » venant des termes « Diamond-Like-Carbon ») par dépôt physique en phase vapeur (également connu sous l'abréviation anglaise « PVD »). Bien entendu, un ou plusieurs autres matériaux peuvent être utilisés en remplaçant ou en adjuvant du carbone. D'autres procédés de dépôt sont également envisageables.

L'étape 11 consiste à libérer chaque pièce 51 du substrat 53. Ainsi, dans l'exemple illustré aux figures, on peut obtenir sur un même substrat 53, selon le procédé 1, plusieurs dizaines de pièces mécaniques 51. L'étape 13 consiste à assembler une attache 91' sur chaque pièce 51 à l'aide d'un contre-support 81' afin que la pièce 51 préassemblée soit prête à être montée sans avoir à toucher la partie en matériau micro-usinable.

Dans l'exemple illustré aux figures 1 à 7, on peut ainsi obtenir, par exemple, des roues d'échappement dont l'âme est en silicium monocristallin et, suivant les modes de réalisation expliqués ci-après, comportant une surface externe en diamant synthétique et, éventuellement, une attache 91 préassemblée.

A partir des étapes principales 3, 5, 7, 9 et 11, il va maintenant être expliqué chacun des modes de réalisation. Dans un premier mode de réalisation, le procédé 1 comporte les étapes consécutives 3, 5, 7, 9 et 11 comme illustré par un trait simple à la figure 8. La première étape 3 consiste à se munir d'un substrat 53 en matériau micro-usinable.

Puis la deuxième étape 5 consiste à réaliser par photolithographie, dans la totalité de l'épaisseur du substrat 53, les motifs 50 comportant chacun une pièce mécanique 51 à fabriquer. Selon le premier mode de réalisation illustré dans le schéma fonctionnel de la figure 8, la deuxième étape 5 comporte trois phases 15, 17 et 19.

Dans une première phase 15, un masque de protection est structuré sur le substrat 53. Préférentiellement, le masque de protection est réalisé à l'aide d'une résine photosensible. Le masque de protection est ainsi formé à l'aide d'un rayonnement sélectif permettant de structurer ledit masque de forme correspondante à chaque motif 50 à réaliser. Grâce à cette étape 15, il sera possible de manière très précise de graver n'importe quelle forme plane de manière sélective sur le substrat 53.

Dans une deuxième phase 17, une attaque par gravure anisotropique de l'ensemble substrat 53 - masque de protection est effectuée. Préférentiellement, une attaque du type gravure ionique réactive profonde est utilisée (également connu sous l'abréviation anglaise « DRIE »). L'attaque anisotropique permet de graver de manière sensiblement rectiligne le substrat 53 au niveau des zones non protégées par ledit masque de protection. Préférentiellement, la gravure lors de la deuxième phase 17 est réalisée sur toute l'épaisseur du substrat 53 et, éventuellement, selon un axe cristallographique du matériau micro-usinable favorable à cette attaque.

De plus de manière préférée selon l'invention, chaque motif 50, comme illustré aux figures 1 et 2, comporte deux ponts de matière 57. Ces derniers autorisent le maintien de la pièce 51 par rapport au substrat 53 jusqu'à l'étape 11. Comme visible à la figure 2, les ponts de matière 57 comportent une section rétrécie à l'extrémité reliée au motif de la pièce 51 permettant de créer une zone de faiblesse apte à faciliter l'étape 11 de libération.

Enfin, selon le premier mode de réalisation, la deuxième phase 17 est également utilisée pour graver dans le substrat 53 des trous 59 formant une partie des moyens d'alignement. Dans l'exemple illustré à la figure 1, on peut voir qu'il a été formé trois trous 59 distribués sensiblement à 120 degrés les uns des autres et à proximité des extrémités du substrat 53.

Dans une troisième et dernière phase 19 de la deuxième étape 5, le masque de protection est retiré de la surface du substrat 53. On obtient alors un substrat 53 comportant plusieurs motifs 50 comprenant une pièce 51 solidaire du substrat 53 par deux ponts de matière 57 comme illustré aux figures 1 et 2. Bien entendu, lors de l'étape 5, il peut être envisagé de réaliser un seul ou plus de deux ponts de matière 57.

Selon le premier mode de réalisation, la troisième étape 7 consiste à monter le substrat 53 gravé sur un support 55' afin de laisser accessibles les faces supérieure et inférieure du substrat 53 dans le but de le préparer à l'étape 9 de dépôt. Comme illustré à la figure 8, la troisième étape 7 comporte les phases 21 et 23.

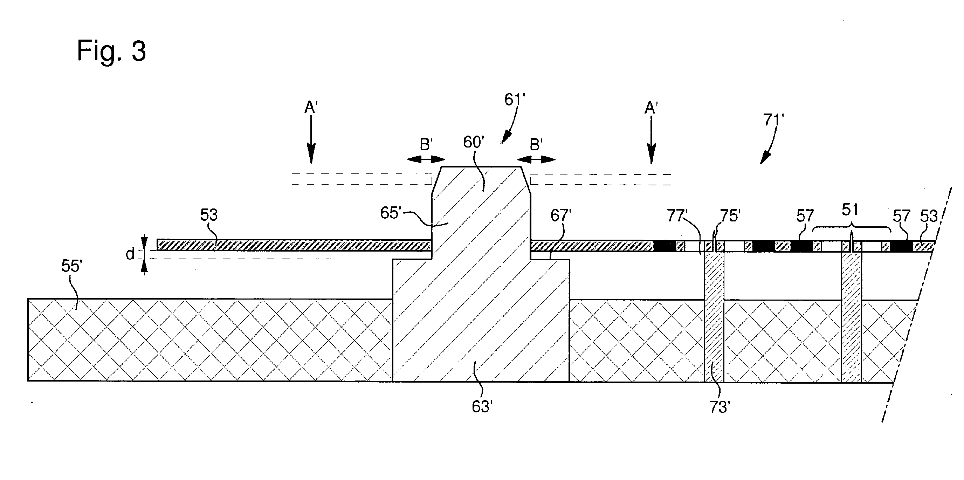

Comme illustré à la figure 3, on peut voir un exemple de support 55' selon le premier mode de réalisation. Le support 55' est une plaque dont le matériau est capable du supporter les températures de l'étape 9 comme, par exemple, une céramique. Afin de permettre la suspension du substrat 53 par rapport au support 55', ce dernier comporte des tiges 61' et des axes 71' destinés respectivement à coopérer avec les évidements 59 et des trous 69 de pièces 51 tous réalisés dans le substrat 53 lors de l'étape 5. Pour les mêmes raisons que le support 55', les tiges 61' et les axes 71' sont préférentiellement en tungstène ou en tantale.

Préférentiellement, chaque tige 61' généralement cylindrique comporte une partie basse 63' reliée à une partie haute 65' de plus faible section au moyen d'un épaulement 67'. La partie basse 63' est montée sensiblement perpendiculairement dans le support 55' de manière fixe. La partie haute 65' comporte en prolongement une colonne chanfreinée 60' appartenant à des moyens d'alignement cités ci-après.

Préférentiellement, chaque axe 71' généralement cylindrique comporte une partie basse 73' reliée à une partie haute 75' de plus faible section au moyen d'un épaulement 77'. La partie basse 73' est également montée sensiblement perpendiculairement dans le support 55' de manière fixe. La partie haute 75' finit par une pointe afin de faciliter son entrée dans son trou 69 associé.

Dans la première phase 21, comme visible à la figure 3, par rapprochement selon la direction A' du substrat 53 par rapport au support 55', le substrat 53 est guidé selon les directions B' à l'aide de moyens d'alignement afin d'orienter fiablement le substrat 53 par rapport au support 55'.

Dans une deuxième phase 23, en continuant le rapprochement selon la translation A', le substrat 53 glisse contre respectivement chaque partie 65' des tiges 61' puis également contre chaque partie 75' des axes 71' jusqu'à ce que le substrat 53 bute sensiblement contre l'épaulement 77' de chaque axe 71'. Comme visible à la figure 3 à la fin de l'étape 7, le substrat 53 est posé de manière stable et a comme degré de liberté unique la translation A' vers le haut. On peut également voir que le substrat 53 est également en hauteur par rapport aux épaulements 67' des tiges 61' selon la distance d illustrée à la figure 3.

Dans l'exemple illustré sur les motifs 50 en bas à droite et en haut à gauche de la figure 2, on peut voir une variante aux moyens d'alignement colonne 60' - trou 59. Cette variante est prévue dans le cas où l'espace aux extrémités du substrat 53 ne permet pas de réaliser les trous 59. Selon la variante, deux colonnes 93, 97 sont prévues pour coopérer chacune avec une partie vide d'un motif 50. Préférentiellement, les deux motifs 50 sont le plus éloigné possible l'un de l'autre et chacun est à proximité des extrémités du substrat 53. Dans l'exemple illustré à la figure 2, on peut voir que chaque colonne 93 et 97 de forme sensiblement trigonale coopère avec un motif 50 différent selon une symétrie centrale afin d'améliorer le guidage de l'étape 21. Préférentiellement, la symétrie est réalisée par rapport au centre du substrat 53 et utilise les motifs 50 en haut à gauche et en bas à droite de l'exemple illustré à la figure 1.

De manière préférée, les moyens d'alignement 60', 59, 93, 97 sont situés plus haut verticalement que les tiges 61' et les axes 71' afin de garantir la consécutivité des phases 21 puis 23.

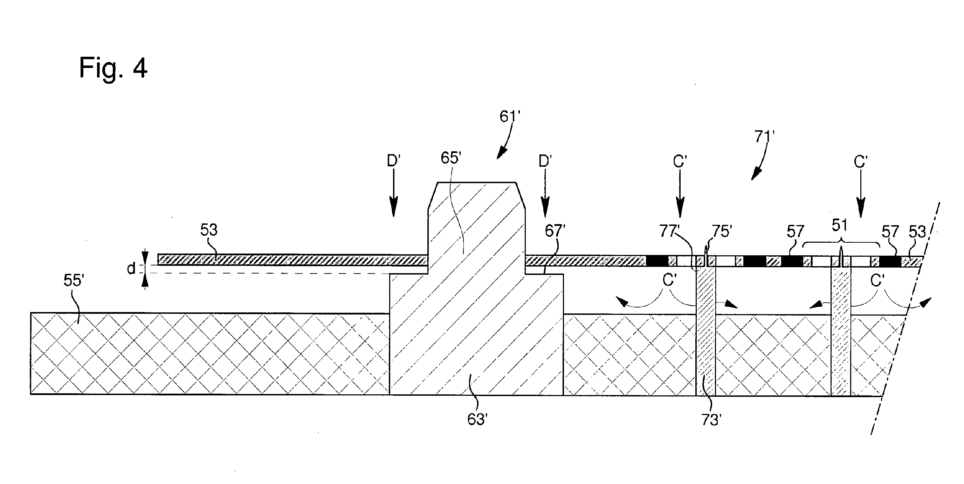

Selon le premier mode de réalisation, la quatrième étape 9 consiste dans une phase 24 à déposer un revêtement sur la surface extérieure de chaque pièce 51. Comme expliqué ci-dessus, le revêtement peut, par exemple, être un allotrope du carbone destiné à améliorer la tribologie de chaque pièce 51, notamment, en diminuant son coefficient de frottement. Comme illustré à la figure 4 par la flèche C', la phase 24 permet de déposer un revêtement en dessous, sur l'épaisseur et au-dessus de chaque pièce 51 grâce à l'étape 7 de mise en hauteur du substrat 53 et au fait que le substrat 53 ait été gravé dans toute son épaisseur lors de l'étape 5.

Selon le premier mode de réalisation, la cinquième étape 11 comporte la phase 26 consistant à libérer chaque pièce 51 du substrat 53. Cette phase 26 est réalisée en déplaçant chaque pièce 51 par rapport au substrat 53 de manière à casser les ponts 57 qui la retienne. La phase 26 peut être réalisée en poussant, selon les flèches D' visibles à la figure 4, le substrat 53 vers les épaulements 67' de chaque tige 61' de manière manuelle ou à l'aide d'un automate.

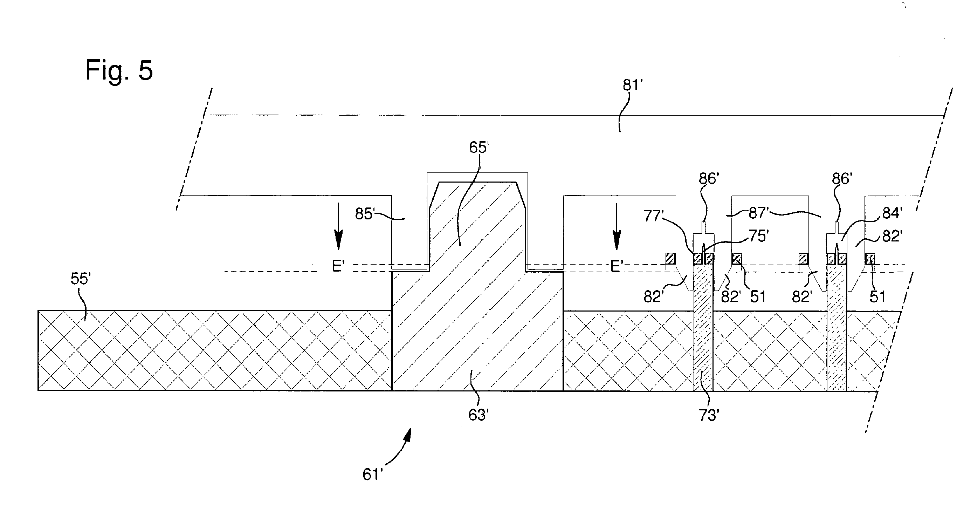

La poussée permet alors de diminuer la distance d entre le substrat 53 et l'épaulement 67' de chaque tige 61'. Cependant, chaque pièce 51 étant déjà en butée contre l'épaulement 77' de son axe 71', la poussée induit donc un déplacement relatif du substrat 53 par rapport à chaque pièce 51 ce qui entraîne une rupture au niveau de l'intersection de chaque pont de matière 57 avec sa pièce 51 associée. On comprend donc qu'à la suite de la phase 26, chaque pièce 51 est maintenue uniquement contre son axe 71' par son trou 69 et, plus bas, le substrat 53 est maintenu contre les épaulements 67' des tiges 61' grâce à ses évidements 59 comme visible en traits interrompus à la figure 5.

On obtient donc de façon simple, selon le premier mode de réalisation du procédé 1, une pièce mécanique 51 dont l'âme en matériau micro-usinable comme, par exemple, du silicium monocristallin est revêtue d'une couche comme, par exemple, du carbone cristallin ou amorphe.

Suite à l'explication du premier mode de réalisation, on s'aperçoit qu'un deuxième mode de réalisation est possible. En effet, du fait que chaque pièce 51 est portée par son axe 71' lors de l'étape 11, il est possible d'inverser les étapes 9 et 11 comme illustré à la figure 8 par un trait double. Ainsi, le procédé 1 selon le deuxième mode de réalisation comporte les étapes consécutives 3, 5, 7, 11 et 9. Les étapes 3, 5 et 7 sont identiques à celles du premier mode de réalisation, elles ne seront donc pas détaillées à nouveau.

Après la troisième étape 7, la quatrième étape 11 comporte la phase 25 consistant à libérer chaque pièce 51 du substrat 53. Cette phase 25 est réalisée en déplaçant chaque pièce 51 par rapport au substrat 53 de manière à casser les ponts 57 qui la retienne. La phase 25 peut être réalisée en poussant, selon les flèches D' visibles à la figure 4, le substrat 53 vers les épaulements 67' de chaque tige 61' de manière manuelle ou à l'aide d'un automate. Chaque pièce 51 est donc portée par son axe 71' solidaire du support 55'. On comprend donc que le substrat 53 peut être retiré.

Selon le deuxième mode de réalisation, la cinquième étape 9 consiste dans une phase 27 à déposer un revêtement sur la surface extérieure de chaque pièce 51. Comme expliqué ci-dessus, le revêtement peut, par exemple, être un allotrope du carbone destiné à améliorer la tribologie de chaque pièce 51, notamment, en diminuant son coefficient de frottement. Comme expliqué ci-dessus, la phase 27 permet de déposer un revêtement en dessous, sur l'épaisseur et au-dessus de chaque pièce 51 grâce à l'étape 7 de mise en hauteur du substrat 53 mais également avantageusement selon le deuxième mode de réalisation au fait que le substrat 53 ait été retiré lors de l'étape 11.

A ce titre, on comprend également, qu'avantageusement selon le deuxième mode de réalisation, l'épaisseur de chaque pièce 51 est revêtue sur une plus grande surface que par le premier mode de réalisation du fait que les ponts de matière 57 ont déjà été retirés avec le substrat 53 lors de la quatrième étape 11.

On obtient donc, selon le deuxième mode de réalisation du procédé 1, de façon aussi simple que le premier mode de réalisation, une pièce mécanique 51 dont l'âme en matériau micro-usinable comme, par exemple, du silicium monocristallin est revêtue d'une couche comme, par exemple, du carbone cristallin ou amorphe.

A la suite de chacun des deux modes de réalisation expliqué ci-dessus, le procédé 1, peut comporter une sixième étape 13 consistant à assembler une attache 91' sur la pièce 51 à l'aide d'un contre-support 81' afin que la pièce 51 préassemblée soit prête à être montée sans avoir à toucher la partie en matériau micro-usinable. L'étape 13 comporte les phases 29, 31 et 33.

La première phase 29 consiste à monter selon la direction E' un contre-support 81', muni de fourchettes 87', sur le support 55' afin que des dents 82' d'une fourchette 87' coopèrent avec chaque pièce 51 et ainsi prépare le montage de l'attache 91'. Comme visible à la figure 5, dans un premier temps par rapprochement selon la direction E' du contre-support 81' par rapport au support 55', le contre-support 81' est guidé à l'aide de moyens d'alignement afin d'orienter fiablement le contre-support 81' par rapport au support 55'.

Préférentiellement, les moyens d'alignements sont formés par la colonne chanfreinée 60' déjà utilisée lors de la phase 21 de l'étape 7, montée en prolongement de l'axe 65', coopérant avec une des parties tubulaires 85' solidaires du contre-support 81'. De manière préférée, le procédé 1 comporte trois moyens d'alignement 60', 85' afin d'améliorer le guidage de la première phase 29.

Dans un deuxième et dernier temps, en continuant le rapprochement selon la translation E' du contre-support 81' par rapport au support 55', chaque fourchette 87' puis le contre-support 81' glissent contre respectivement une pièce 51 et chaque partie 65' des axes 61' tous portés par le support 55'. Le deuxième temps s'achève lorsque le contre-support 81' butent contre l'épaulement 67' de chaque axe 61 '.

Comme visible à la figure 5 à la fin de la phase 29, le contre-support 81' recouvre partiellement chaque axe 71' en passant à travers une pièce 51 associée mais également les parties hautes 65' de chaque axe 61'. Dans l'exemple illustré sur le motif en haut à droite de la figure 2, on peut voir trois dents 82' d'une fourchette 87' dont la forme correspond chacune à l'interstice libre entre deux bras de la roue d'échappement 51. Bien entendu, suivant la pièce 51 fabriquée, les fourchettes 87' seront adaptées. Préférentiellement, le contre-support 81' est formé à partir d'un matériau qui ne blesse pas la pièce 51 comme, par exemple, un polymère plastique.

De manière préférée, les moyens d'alignement 60', 85' sont situés plus haut verticalement que les axes 61' et les pièces 51 afin de garantir la consécutivité du premier temps puis du deuxième temps.

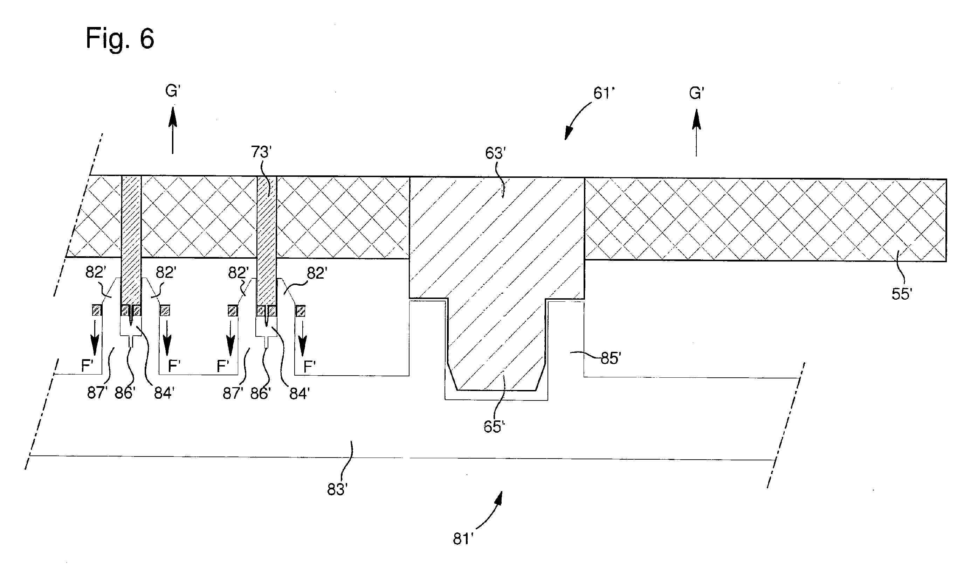

Dans une deuxième phase 31 comme illustré à la figure 6, l'ensemble support 55' - contre-support 81' est retourné puis le support 55' est retiré selon la direction G' afin de faire coulisser selon la direction F' chaque pièce 51 contre les dents 82' des fourchettes 87' jusqu'à ce que ces premières reposent chacune contre le fond de l'espace 84' délimité par les dents 82'.

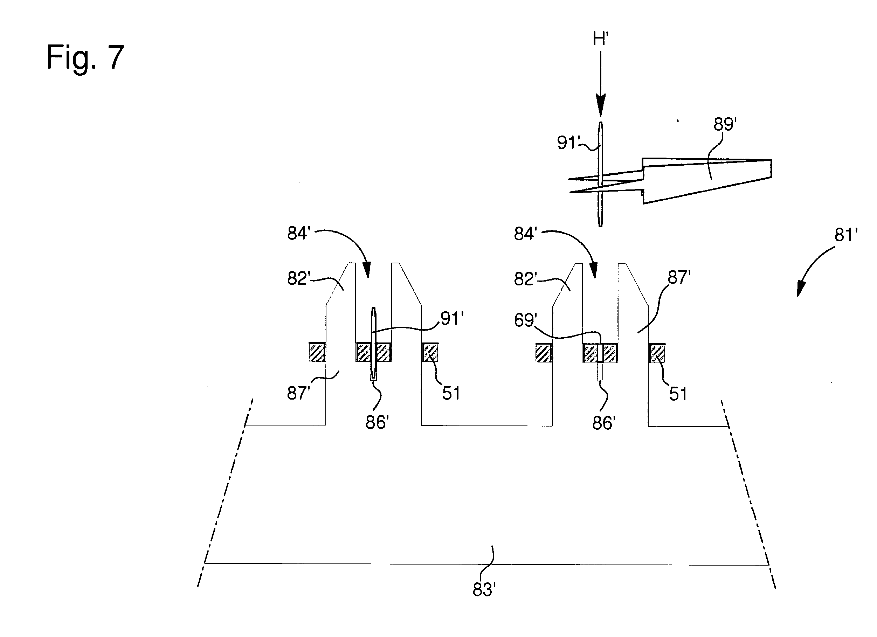

Dans la troisième phase 33 de la sixième étape 13, une attache 91' est assemblée sur chaque pièce 51 montée contre le contre-support 81'. Dans l'exemple illustré à la figure 7, on peut voir une première pièce 51 assemblée et une deuxième pièce 51 plus à droite dont l'attache 91' n'est pas encore assemblée. Bien entendu, cette figure 7 est utilisée pour une meilleure compréhension. En effet, le montage des attaches 91' ne saurait se limiter à un assemblage un à un à l'aide de brucelles 89' mais peut bien évidemment être réalisé en même temps pour chaque pièce 51 à l'aide d'un automate.

Comme visible sur la pièce 51 de droite non assemblée, dans un premier temps, l'attache 91' est déplacée selon la translation H' vers le centre percé 69 de la pièce 51 contenu dans l'espace 84' délimité par les dents 82'. Préférentiellement, la translation maximale de l'attache 91' par rapport au centre 69 est délimitée par la hauteur du trou 86' réalisé en prolongement de l'espace 84' ce qui permet de monter fiablement l'attache 91' par rapport à la pièce 51.

Dans un deuxième temps, une fois toutes les attaches 91' mises sur toutes les pièces 51, on solidarise définitivement l'attache 91' et la pièce 51, par exemple, en les chauffant dans un four afin que la colle, présente sur chaque attache 91', se polymérise ce qui a pour effet de solidariser chaque attache 91' dans son centre 69 associé.

A la fin de l'étape 13, on obtient donc un contre-support 81' portant des pièces 51 préassemblées. Avantageusement selon l'invention, les dizaines de pièces 51 sont donc toujours manipulables ensemble et peuvent être fournies avec le contre-support 81' directement sur une ligne de fabrication d'un dispositif, comme, par exemple, un mouvement de pièce d'horlogerie. Il devient dès lors possible de déplacer chaque pièce 51 en saisissant directement l'attache 91' ce qui permet le montage final de chaque pièce 51 sans aucune manipulation directe sur le matériau micro-usinable et/ou le revêtement déposé.

Dans l'exemple illustré aux figures 1 et 2, la pièce 51 est une roue d'échappement et l'attache 91', son axe de pivotement. Cependant l'invention ne saurait s'y limiter et, à titre d'exemple, la pièce 51 pourrait être un autre type de rouage, une couronne ou même un ensemble spiral - virole de même que l'attache 91' pourrait être une autre pièce fonctionnelle qu'un axe de pivotement.

Bien entendu, la présente invention ne se limite pas à l'exemple illustré mais est susceptible de diverses variantes et modifications qui apparaîtront à l'homme de l'art. En particulier, l'étape 9 est prévue pour le cas où le matériau micro-usinable comporte des caractéristiques tribologiques insuffisantes pour l'application prévue de la pièce 51. Cependant, dans le cas où le matériau micro-usinable comporterait des caractéristiques suffisantes, le procédé 1 selon un troisième mode de réalisation pourrait comporter les étapes consécutives 3, 5, 7, 11 et, éventuellement, l'étape 13.

Enfin, le déplacement relatif de l'étape 11 entre les pièces 51 et le substrat 53 des premier et deuxième modes de réalisation ne saurait se limiter au déplacement selon la direction D'. Ainsi, le déplacement relatif pourrait être effectué par tout moyen comme, par exemple, par des axes 71' et/ou des tiges 61' montés mobiles par rapport au support 55'.

## Revendications

1. Procédé de fabrication (1) d'une pièce mécanique (51) comportant les étapes suivantes :
a) se munir (3) d'un substrat (53) en un matériau micro-usinable ;
b) graver (5) par photolithographie, dans la totalité de l'épaisseur dudit substrat, un motif (50) comportant ladite pièce ;
**caractérisé en ce qu'**il comporte en outre les étapes suivantes :
c) monter (7) sur un support (55') ledit substrat gravé afin de laisser accessibles les faces supérieure et inférieure de ce dernier ;
d) déposer (9, C') un revêtement sur la surface extérieure de ladite pièce de meilleure qualité tribologique que ledit matériau micro-usinable ;
e) libérer (11) la pièce du substrat.

2. Procédé selon la revendication 1, **caractérisé en ce que** l'étape c) comporte les étapes suivantes :
f) guider (21, B') le substrat (53) par rapport audit support à l'aide de moyens d'alignement (60', 59, 93, 97) afin d'orienter fiablement ledit substrat ;
g) glisser (23, A') le substrat (53) contre au moins un axe (71', 61') solidaire du support (55') jusqu'à buter contre un épaulement (77') dudit au moins un axe réalisé à distance dudit support afin de maintenir en hauteur le substrat (53) par rapport audit support.

3. Procédé selon la revendication 2, **caractérisé en ce que** les moyens d'alignement (60', 59, 93, 97) sont situés plus haut que ledit au moins un axe afin de garantir la consécutivité des étapes f) puis g).

4. Procédé selon la revendication 2 ou 3, **caractérisé en ce que** le support (55') comporte plusieurs moyens d'alignement (60', 59, 93, 97) afin d'améliorer le guidage de l'étape f).

5. Procédé selon l'une des revendications 2 à 4, **caractérisé en ce que** les moyens d'alignement comportent au moins une colonne (60', 93, 97) solidaire du support (55') destinée à coopérer avec un évidement (59, 50) réalisé dans le substrat (53) lors de l'étape b).

6. Procédé selon la revendication 5, **caractérisé en ce que** chaque évidement (59) est réalisé à proximité des extrémités du substrat (53).

7. Procédé selon la revendication 5, **caractérisé en ce que** chaque évidement correspond à un espace vide du motif (50).

8. Procédé selon l'une des revendications précédentes, **caractérisé en ce que**, lors de l'étape b), au moins un pont de matière (57) est gravé dans le motif (50) afin de maintenir solidaire la pièce (51) avec le substrat (53).

9. Procédé selon la revendication 8, **caractérisé en ce que** ledit au moins un pont de matière comporte une section rétrécie à l'extrémité reliée à ladite pièce permettant de créer une zone de faiblesse apte à faciliter l'étape e).

10. Procédé la revendication 8 ou 9, **caractérisé en ce que** l'étape e) est réalisée par déplacement relatif entre le substrat (53) et la pièce (51) afin de casser ledit au moins un pont de matière (57).

11. Procédé selon l'une des revendications précédentes, **caractérisé en ce qu'**il comporte en outre, après l'étape e), l'étape suivante :
h) assembler (13) une attache (91') sur ladite pièce afin que cette dernière soit prête à être montée sans avoir à toucher la partie en matériau micro-usinable.

12. Procédé selon la revendication 11, **caractérisé en ce que** l'étape h) comporte les étapes suivantes :
i) monter (29) un contre-support (81') munis de fourchettes (87') sur ledit support (55') afin que les fourchettes (87') coopèrent avec ladite pièce ;
j) retourner (31) l'ensemble support (55') - contre-support (81') puis retirer le support (55') afin de faire coulisser ladite pièce contre les fourchettes (87') ;
k) monter (33) une attache (91') sur la pièce (51).

13. Procédé selon la revendication 12, **caractérisé en ce que** l'étape i) comporte les étapes suivantes :
- guider le contre-support (81') par rapport audit support à l'aide de moyens d'alignement (85', 60') afin d'orienter fiablement ledit contre-support ;
- glisser (E') au moins un tube (85') et les fourchettes (87') contre respectivement un axe (61') solidaire du support (55') et la pièce (51) jusqu'à buter contre un épaulement (67') dudit axe afin de préparer le retournement de l'ensemble support (55') - contre-support (81').

14. Procédé selon l'une des revendications précédentes, **caractérisé en ce que** les étapes e) et d) sont interverties.

15. Procédé selon l'une des revendications précédentes, **caractérisé en ce que** le substrat (53) est aminci entre l'étape a) et b) afin d'adapter l'épaisseur finale de la pièce (51).

16. Procédé selon l'une des revendications précédentes, **caractérisé en ce que** plusieurs pièces (51) sont fabriquées à partir du même substrat (53).

17. Procédé selon l'une des revendications précédentes, **caractérisé en ce que** l'étape b) comporte les étapes suivantes :
- structurer (15) sur le substrat (53) un masque de protection de forme correspondante à ladite pièce ;
- attaquer (17) par gravure anisotropique l'ensemble substrat - masque ;
- retirer (19) ledit masque de protection.

18. Procédé selon la revendication 17, **caractérisé en ce que** ledit masque de protection est réalisé à l'aide d'une résine photosensible.

19. Procédé selon l'une des revendications précédentes, **caractérisé en ce que** ledit matériau micro-usinable étant choisi parmi le groupe comprenant du silicium cristallin, de la silice cristalline et de l'alumine cristalline.

20. Procédé selon l'une des revendications précédentes, **caractérisé en ce que** la pièce mécanique (51) est destinée à être montée dans une pièce d'horlogerie.

## Patentansprüche

1. Verfahren zum Herstellen (1) eines mechanischen Teils (51), das die folgenden Schritte umfasst:
a) Vorsehen (3) eines Substrats (53) aus einem mikrobearbeitbaren Material; und
b) Ätzen (5) eines Musters (50), das das Teil enthält, durch Photolithographie durch die gesamte Dicke des Substrats;
**dadurch gekennzeichnet, dass** es außerdem die folgenden Schritte umfasst:
c) Montieren (7) des geätzten Substrats auf einem Träger (55'), so dass die obere und die untere Fläche des Substrats zugänglich bleiben;
d) Ablagern (9, C') einer Beschichtung, die eine bessere tribologische Qualität als das mikrobearbeitbare Material hat, auf der äußeren Oberfläche des Teils; und
e) Befreien (11) des Teils von dem Substrat.

2. Verfahren nach Anspruch 1, **dadurch gekennzeichnet, dass** der Schritt c) die folgenden Schritte umfasst:
f) Führen (21, B') des Substrats (53) in Bezug auf den Träger mit Hilfe von Ausrichtmittein (60', 59, 93, 97), um das Substrat zuverlässig zu orientieren;
g) gleitendes Bewegen (23, A') des Substrats (53) gegen wenigstens eine mit dem Träger (55') fest verbundene Achse (71', 61'), bis es an einer Schulter (77') der wenigstens einen Achse anliegt, die in einem Abstand von dem Träger verwirklicht ist, um die Höhe des Substrats (53) in Bezug auf den Träger beizubehalten.

3. Verfahren nach Anspruch 2, **dadurch gekennzeichnet, dass** die Ausrichtmittel (60', 59, 93, 97) höher als die wenigstens eine Achse angeordnet sind, um die Abfolge der Schritte f) und dann g) zu gewährleisten.

4. Verfahren nach Anspruch 2 oder 3, **dadurch gekennzeichnet, dass** der Träger (55') mehrere Ausrichtmittel (60', 59, 93, 97) umfasst, um die Führung des Schrittes f) zu verbessern.

5. Verfahren nach einem der Ansprüche 2 bis 4, **dadurch gekennzeichnet, dass** die Ausrichtmittel wenigstens eine Säule (60', 93, 97) umfassen, die mit dem Träger (55') fest verbunden ist und dazu bestimmt ist, während des Schrittes b) mit einer im Substrat (53) verwirklichten Aussparung (59, 50) zusammenzuwirken.

6. Verfahren nach Anspruch 5, **dadurch gekennzeichnet, dass** jede Aussparung (59) in der Nähe der Enden des Substrats (53) verwirklicht ist.

7. Verfahren nach Anspruch 5, **dadurch gekennzeichnet, dass** jede Aussparung einem leeren Raum des Musters (50) entspricht.

8. Verfahren nach einem der vorhergehenden Ansprüche, **dadurch gekennzeichnet, dass** während des Schrittes b) wenigstens eine Materialbrücke (57) in das Muster (50) geätzt wird, um das Teil (51) mit dem Substrat (53) fest verbunden zu halten.

9. Verfahren nach Anspruch 8, **dadurch gekennzeichnet, dass** die wenigstens eine Materialbrücke an dem mit dem Teil verbundenen Ende einen verengten Querschnitt aufweist, der ermöglicht, eine Schwächungszone zu erzeugen, die den Schritt e) erleichtern kann.

10. Verfahren nach Anspruch 8 oder 9, **dadurch gekennzeichnet, dass** der Schritt e) durch relative Verlagerung zwischen dem Substrat (53) und dem Teil (51) ausgeführt wird, um die wenigstens eine Materialbrücke (57) zu zerbrechen.

11. Verfahren nach einem der vorhergehenden Ansprüche, **dadurch gekennzeichnet, dass** es außerdem nach dem Schritt e) den folgenden Schritt umfasst:
h) Anbringen (13) einer Befestigung (91') an dem Teil, damit dieses Letztere montiert werden kann, ohne das Teil aus mikrobearbeitbarem Material berühren zu müssen.

12. Verfahren nach Anspruch 11, **dadurch gekennzeichnet, dass** der Schritt h) die folgenden Schritte umfasst:
i) Montieren (29) eines mit Gabeln (87') versehenen Gegenträgers (81') an dem Träger (55'), damit die Gabeln (87') mit dem Teil zusammenwirken;
j) Umdrehen (31) der Gesamtheit aus Träger (55') und Gegenträger (81') und dann Entnehmen des Trägers (55'), um das Teil gegen die Gabeln (87') gleiten zu lassen;
k) Montieren (33) einer Befestigung (91') an dem Teil (51).

13. Verfahren nach Anspruch 12, **dadurch gekennzeichnet, dass** der Schritt i) die folgenden Schritte umfasst:
- Führen des Gegenträgers (81') in Bezug auf den Träger mit Hilfe von Ausrichtmitteln (85', 60), um den Gegenträger zuverlässig zu orientieren;
- gleitendes Bewegen (E') wenigstens eines Rohrs (85') und der Gabeln (87') gegen eine mit dem Träger (55') fest verbundene Achse (61') bzw. das Teil (51), bis sie an einer Schulter (67') der Achse anliegen, um das Umdrehen der Gesamtheit aus Träger (55') und Gegenträger (81') vorzubereiten.

14. Verfahren nach einem der vorhergehenden Ansprüche, **dadurch gekennzeichnet, dass** die Schritte e) und d) vertauscht sind.

15. Verfahren nach einem der vorhergehenden Ansprüche, **dadurch gekennzeichnet, dass** das Substrat (53) zwischen den Schritten a) und b) verdünnt wird, um eine Anpassung der endgültigen Dicke des Teils (51) vorzunehmen.

16. Verfahren nach einem der vorhergehenden Ansprüche, **dadurch gekennzeichnet, dass** ausgehend von demselben Substrat (53) mehrere Teile (51) hergestellt werden.

17. Verfahren nach einem der vorhergehenden Ansprüche, **dadurch gekennzeichnet, dass** der Schritt b) die folgenden Schritte umfasst:
- Strukturieren (15) einer Schutzmaske mit einer dem Teil entsprechenden Form auf dem Substrat (53);
- Angreifen (17) durch anisotrope Ätzung der Gesamtheit aus Substrat und Maske;
- Entnehmen (19) der Schutzmaske.

18. Verfahren nach Anspruch 17, **dadurch gekennzeichnet, dass** die Schutzmaske mit Hilfe eines lichtempfindlichen Harzes hergestellt wird.

19. Verfahren nach einem der vorhergehenden Ansprüche, **dadurch gekennzeichnet, dass** das mikrobearbeitbare Material aus der Gruppe gewählt ist, die kristallines Silicium, kristallines Siliciumdioxid und kristallines Aluminiumoxid umfasst.

20. Verfahren nach einem der vorhergehenden Ansprüche, **dadurch gekennzeichnet, dass** das mechanische Teil (51) dazu bestimmt ist, in einem Zeitmessgerät montiert zu werden.

## Claims

1. Method (1) of manufacturing a mechanical part (51) including the following steps:
a) providing (3) a substrate (53) made of micro-machinable material;
b) etching (5), with help of photolithography, a pattern (50) that includes said part through said entire substrate;
**characterized in that** it further includes the following steps:
c) mounting (7) said etched substrate on a support (55') so as to leave the top and bottom surfaces of said substrate accessible;
d) depositing (9, C') a coating of better tribological quality than said micro-machinable material on the outer surface of said part
e) releasing (11) the part from the substrate.

2. Method according to claim 1, **characterized in that** step c) includes the following steps:
f) guiding (21, B') the substrate (53) relative to said support using alignment means (60', 59, 93, 97) so as to orient said substrate in a reliable manner;
g) sliding (23, A') the substrate (53) against at least one pin (71', 61') secured to the support (55') until the substrate abuts against a shoulder (77') of said at least one pin made at a distance from said support so a to keep the substrate (53) high up relative to said support.

3. Method according to claim 2, **characterized in that** the alignment means (60', 59, 93, 97) are located higher than said at least one pin and said forks so as to guarantee the consecutiveness of steps f) then g).

4. Method according to claim 2 or 3, **characterized in that** the support (55') includes several alignment means (60', 59, 93, 97) so as to improve the guiding in step f).

5. Method according to any of claims 2 to 4, **characterized in that** the alignment means include at least one column (60', 59, 93, 97) secured to the support (55') for cooperating with a recess (59, 50) made in the substrate (53) in step b).

6. Method according to claim 5, **characterized in that** each recess (59) is made in proximity to the ends of the substrate (53).

7. Method according to claim 5, **characterized in that** each recess corresponds to an empty space in the pattern (50).

8. Method according to any of the preceding claims, **characterized in that**, in step b), at least one bridge of material (57) is etched in the pattern (50) so as to keep part (51) secured to the substrate (53).

9. Method according to claim 8, **characterized in that** said at least one bridge of material includes a narrow section at the end connected to said part for creating a zone of weakness that facilitates step e).

10. Method according to claim 8 or 9, **characterized in that** step e) is achieved by a relative movement between the substrate (53) and the part (51) so as to break said at least one bridge of material (57).

11. Method according to any of the preceding claims, **characterized in that** it further includes the following step after step e):
h) assembling (13) a clip (91') on said part so that the part is ready to be mounted without the part made of micro-machinable material having to be touched.

12. Method according to claim 11, **characterized in that** step h) includes the following steps:
i) mounting (29) a counter-support (81') fitted with forks (87') on said support (55') so that the forks (87') cooperate with said part;
j) turning over (31) the support (55') - counter-support (81') assembly then removing the support (55') so as to slide said part against the forks (87');
k) mounting (33) a clip (91') on the part (51).

13. Method according to claim 12, **characterized in that** step i) includes the following steps:
- guiding the counter-support (81') relative to said support using alignment means (85', 60') so as to orient said counter-support in a reliable manner;
- sliding (E') at least one tube (85') and the forks (87') respectively against a pin (61') secured to the support (55') and the part (51) until said tube and said forks abut against a shoulder (67') of said pin so as to prepare to turn over the support (55')-counter support (81') assembly.

14. Method according to any of the preceding claims, **characterized in that** steps e) and d) are inverted.

15. Method according to any of the preceding claims, **characterized in that** the substrate (53) is thinned between steps a) and b) so as to adapt the final thickness of the part (51).

16. Method according to any of the preceding claim, **characterized in that**, **in that** several parts (51) are manufactured from the same substrate (53).

17. Method according to any of the preceding claims, **characterized in that** step b) includes the following steps:
- structuring (15) a protective mask in a shape matching said part on the substrate (53),
- anisotropic etching (17) the substrate-mask assembly;
- removing (19) said protective mask.

18. Method according to claim 17, **characterized in that** said protective mask is made using a photosensitive resin.

19. Method according to any of the preceding claims, **characterized in that** said micro-machinable material is chosen from among the group comprising crystalline silicon, crystalline silica and crystalline alumina.

20. Method according to any of the preceding claims, **characterized in that** the micro-mechanical part (51) is for mounting in a timepiece.
